# EUROPEAN PATENT APPLICATION

(11) **EP 3 675 271 A1**
(43) Date of publication of application: **01.07.2020**
(21) Application number: 19204548.2
(22) Date of filing: 22.10.2019
(51) Int. Cl.: H01M 10/42, H01M 2/20, H05K 1/00, H01M 2/10

(54) **BATTERY MODULE**

(30) Priority: 29.12.2018 CN 201822246564 U
(71) Applicant: Contemporary Amperex Technology Co., Limited, Ningde, Fujian 352100 (CN)
(72) Inventor: CHEN, Shaozhen, Ningde City, Fujian Province 352100 (CN); SU, Lilei, Ningde City, Fujian Province 352100 (CN); WANG, Chong, Ningde City, Fujian Province 352100 (CN); ZHENG, Renwei, Ningde City, Fujian Province 352100 (CN)
(74) Representative: Rösler Rasch van der Heide & Partner

(57) **Abstract**

The present utility model provides a battery module, comprising: a plurality of batteries arranged in a length direction (L); an end plate (2), disposed at the end part of the plurality of batteries in the length direction (L) ; an FPC (3), wherein the FPC (3) comprises a main body portion (31) and a bent portion (32), the main body portion (31) is located above the corresponding battery (1) in a height direction (H) and is electrically connected to the corresponding battery (1), the bent portion (32) is bent and extends from the main body portion (31) and is located on the lower side of the main body portion (31), and the bent portion (32) is fixedly connected to the end plate (2); and a connector (4), fixedly connected to the bent portion (32) of the FPC (3) and electrically connected to the FPC (3). In the battery module according to the utility model, the connector (4) is fixedly connected to the bent portion (32) of the FPC (3), and the bent portion (32) is fixedly connected to the end plate (2). Therefore, the connector (4) is fixed to the end plate (2) by the FPC (3). When the connector (4) is subjected to vibration shock, the flexible characteristic of the FPC (3) can be used to transfer and release the shock.

## Description

### Technical field

The utility model relates to the field of batteries, and in particular to a battery module.

### Prior art

In many current battery modules, the batteries of the battery module are usually subjected to low-voltage sampling by using a flexible printed circuit (FPC). The FPC needs to be connected to an external device by a connector, and the FPC is a soft material per se, so a fixing structure needs to be added in the battery module to fix the connector. The usual manner is to add a plastic member for fixing. Then the following unbeneficial effects will be caused: the problem about the fixing of the added plastic member per se exists, basically, the plastic member is fixed above the end plate, and may exceed the maximum height of the battery module, and occupy the space of the battery module; the connector and the plastic member fixed thereby require a relatively large groove disposed on the end plate, which leads to stress concentration of the end plate, as a result, the expansion resistance of the entire battery module is reduced; and when the connector is subjected to vibration shock, the added plastic member cannot effectively transfer and release the impact applied to the connector.

### Summary of the utility model

In view of the defects of the prior art, an object of the utility model is to provide a battery module which can effectively transfer and release the impact of a connector when the connector is impacted.

In order to achieve the above object, the utility model provides a battery module, comprising: a plurality of batteries arranged in a length direction; an end plate, disposed at the end part of the plurality of batteries in the length direction; an FPC, wherein the FPC comprises a main body portion and a bent portion, the main body portion is located above the corresponding battery in a height direction and is electrically connected to the corresponding battery, the bent portion is bent and extends from the main body portion and is located on the lower side of the main body portion, and the bent portion is fixedly connected to the end plate; and a connector, fixedly connected to the bent portion of the FPC and electrically connected to the FPC.

In an embodiment, the battery module further comprises: a connecting plate, connected to the end plate and the bent portion of the FPC.

In an embodiment, the connector and the connecting plate are respectively located on opposite sides of the bent portion of the FPC.

In an embodiment, the end plate is provided with two protrusions protruding upward from the top of the end plate, a containing space is formed between the two protrusions, and the main body portion and the bent portion of the FPC are overlapped in the height direction; the connecting plate is located between the main body portion and the bent portion of the FPC in the height direction, and the connecting plate is fixed to the two protrusions; and the connector is located in the containing space, and an inserting port of the connector faces the outside of the battery module in the length direction.

In an embodiment, the battery module further comprises a first fastener and a second fastener which are respectively located on both sides of the connector in a width direction, and the connecting plate, the main body portion of the FPC, the bent portion of the FPC, and the protrusions of the end plate are fixed by the first fastener and the second fastener.

In an embodiment, the bent portion of the FPC extends downward from the top of the end plate along the outer surface of the end plate in the length direction; the connecting plate is located between the bent portion of the FPC and the outer surface of the end plate in the length direction, and is fixed to the outer surface of the end plate in the length direction; and the inserting port of the connector is disposed in the width direction.

In an embodiment, the connecting plate comprises an exposed portion downward exceeding the bottom end of the bent portion of the FPC, and the exposed portion is located on the lower side of the connector and is fixed to the outer surface of the end plate in the length direction.

In an embodiment, the battery module further comprises a third fastener, and the exposed portion and the outer surface of the end plate are fixed by the third fastener.

In an embodiment, the battery module further comprises a fourth fastener located on the upper side of the connector, and the connecting plate, the outer surface of the end plate and the bent portion of the FPC are fixed by the fourth fastener.

In an embodiment, the battery module further comprises a third fastener and a fourth fastener; the connecting plate comprises an exposed portion downward exceeding the bottom end of the bent portion of the FPC, and the exposed portion is located on the lower side of the connector, and is fixed to the outer surface of the end plate in the length direction by the third fastener; and the fourth fastener is located on the upper side of the connector, and the connecting plate, the outer surface of the end plate, and the bent portion of the FPC are fixed by the fourth fastener.

In an embodiment, the connecting plate comprises an exposed portion exceeding both ends of the bent portion in the width direction, and the exposed portion is located on both sides of the connector in the width direction and is fixed to the outer surface of the end plate in the length direction.

The utility model has the following beneficial effects:
In the battery module according to the utility model, the connector is fixedly connected to the bent portion of the FPC, and the bent portion is fixedly connected to the end plate. Therefore, the connector is fixed to the end plate by the FPC. When the connector is subjected to vibration shock, the flexible characteristic of the FPC can be used to transfer and release the shock.

### Brief description of the attached figures

FIG. 1 is a three-dimensional diagram of a battery module according to an embodiment of the utility model.
FIG. 2 is a three-dimensional diagram of the battery module of FIG. 1 from another angle.
FIG. 3 is an enlarged three-dimensional diagram of the circle A in FIG. 2 from another angle.
FIG. 4 is an exploded three-dimensional diagram of part of components of the battery module of FIG. 1.
FIG. 5 is a three-dimensional diagram of the battery module according to another embodiment of the utility model.
FIG. 6 is an enlarged three-dimensional diagram of the circle B in FIG. 5 from another angle.
FIG. 7 is an exploded three-dimensional diagram of part of components of the battery module of FIG. 4.
FIG. 8 is a partially enlarged three-dimensional diagram of part of the components of the battery module of FIG. 4.
FIG. 9 is an exploded three-dimensional diagram of part of components of the battery module of FIG. 8.

### Reference signs in the drawings

- 1: Battery
- 2: End plate
- 21: Protrusion
- 211: Top wall
- 22: Outer surface
- 23: Cavity
- 231: Wall
- 3: FPC
- 31: Main body portion
- 32: Bent portion
- 4: Connector
- 41: Inserting port
- 5: Connecting plate
- 51: Exposed portion
- 6: Electrical connecting piece
- G: Buckling groove
- F1: First fastener
- F2: Second fastener
- F3: Third fastener
- F4: Fourth fastener
- S: Containing space
- L: Length direction
- W: Width direction
- H: Height direction

### Detailed embodiments

The drawings illustrate the embodiments of the utility model, it is understood that the disclosed embodiments are only examples of the utility model, and the utility model can be implemented in various forms. Therefore, the specific details disclosed herein should be explained only as the basis of claims rather than limiting, and are intended to teach those ordinary skilled in the art to implement the utility model in various forms as a representative basis.

The battery module according to the utility model comprises: a plurality of batteries 1 arranged in a length direction L; an end plate 2 disposed at an end part of the plurality of batteries 1 in the length direction L; an FPC 3, comprising a main body portion 31 and a bent portion 32, wherein the main body portion 31 is located above the corresponding battery 1 in a height direction H and is electrically connected to the corresponding battery 1, the bent portion 32 is bent and extends from the main body portion 31 and is located on the lower side of the main body portion 31, and the bent portion 32 is fixedly connected to the end plate 2; a connector 4, fixedly connected to the bent portion 32 of the FPC 3 and electrically connected to the FPC 3. The battery module further comprises a connecting plate 5 connected to the end plate 2 and the bent portion 32 of the FPC 3. The FPC 3 is a flexible board, and the connecting plate 5 plays a role of strengthening the hardness of the FPC 3 and complementing the thickness of the FPC 3. A material of the connecting plate 5 can be plastic or other insulating materials.

The battery 1 can be a hard-shell battery (or referred to as a can-type battery) or a soft-pack battery (or referred to as a bag-type battery), and the hard-shell battery comprises an electrode component (not shown), a pole, an explosion-proof valve, a housing, and a top cover. A containing cavity is formed inside the housing to accommodate the electrode component and electrolyte. The electrode component comprises a positive electrode plate, a negative electrode plate, and a separating film separating the positive electrode plate from the negative electrode plate. The electrode component can be formed by winding the positive electrode plate, the negative electrode plate, and the separating film, or laminating the positive electrode plate, the negative electrode plate, and the separating film. Each of the positive electrode plate and the negative electrode plate comprises a current collector and an active material layer disposed on the current collector. The soft-pack battery comprises a package bag as a battery case (for example, formed by an aluminum plastic film), an electrode component (similar to the formation and molding of the hard-shell battery), and a tab. A part of the tab is packaged within the package bag and the other part extends out of the package bag. The tab can be formed directly by a pole piece or can adopt a separate conductive material and is electrically connected to the current collector.

The bent portion 32 of the FPC 3 can be fixedly connected to the end plate 2 in multiple fixing manners, comprising that the bent portion 32 of the FPC 3 is fixedly connected to the outer surface 22 of the end plate 2 and the bent portion 32 of the FPC 3 is fixedly connected to the top of the end plate 2.

The following will explain the fixing manner in which the bent portion 32 of the FPC 3 is fixedly connected to the outer surface 22 of the end plate 2.

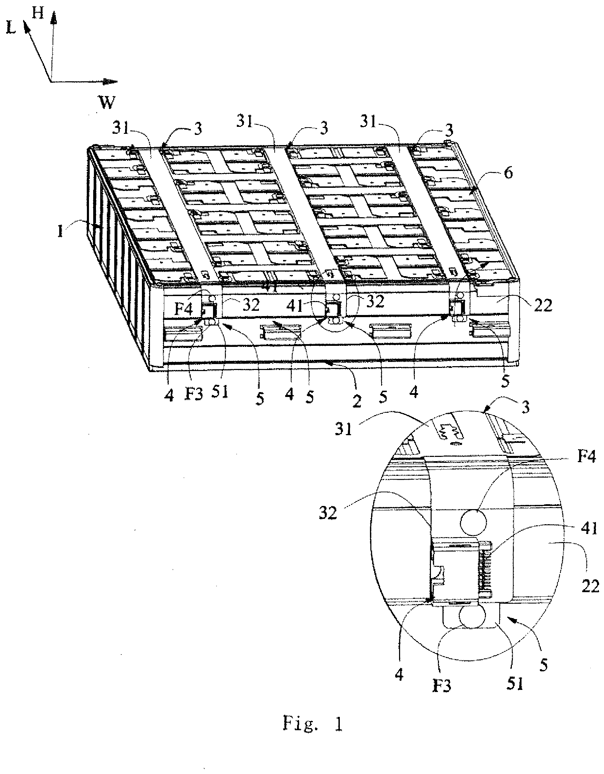

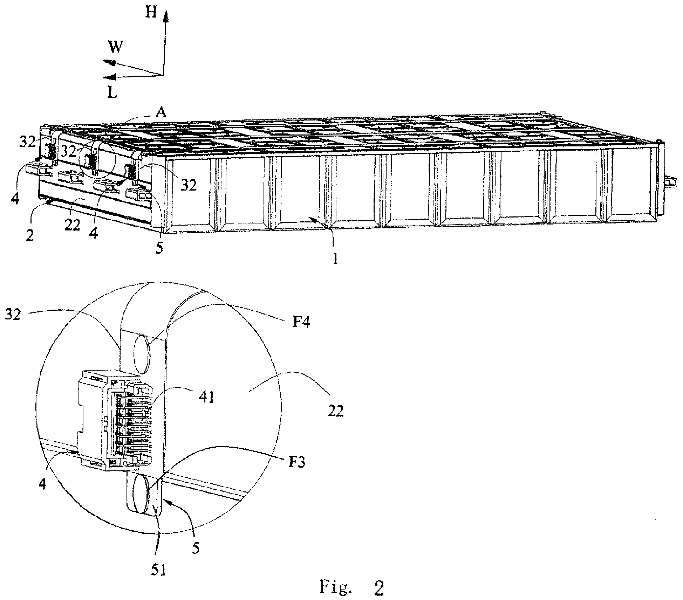

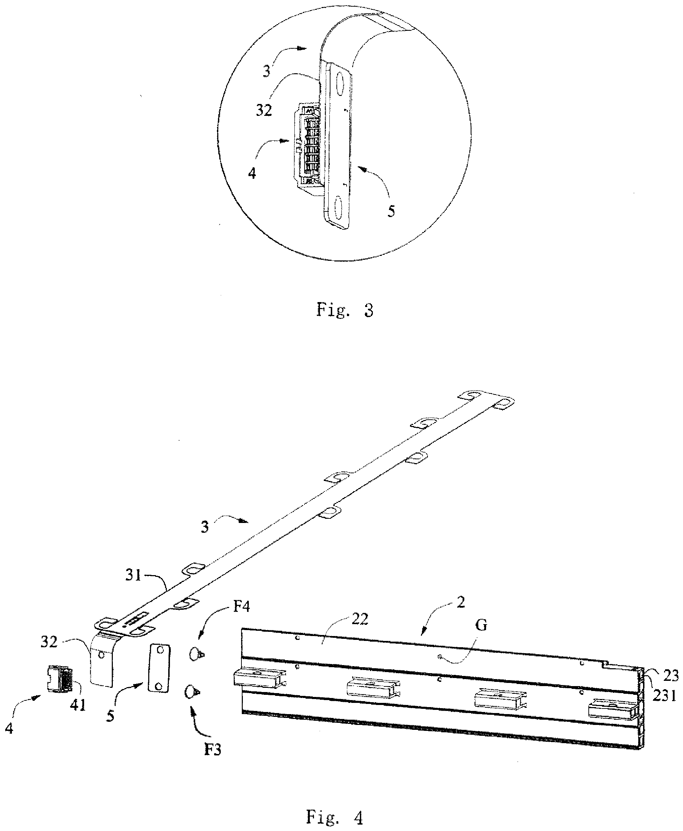

FIG. 1 is a three-dimensional diagram of a battery module according to an embodiment of the utility model. FIG. 2 is a three-dimensional diagram of the battery module of FIG. 1 from another angle. FIG. 3 is an enlarged three-dimensional diagram of the circle A in FIG. 2 from another angle. FIG. 4 is an exploded three-dimensional diagram of part of components of the battery module of FIG. 1.

In the embodiment shown in FIG. 1 to FIG. 4, the bent portion 32 of the FPC 3 extends downward from the top of the end plate 2 along the outer surface 22 of the end plate 2 in the length direction L. The connecting plate 5 is located between the bent portion 32 of the FPC 3 and the outer surface 22 of the end plate 2 in the length direction L, and is fixed to the outer surface 22 of the end plate 2 in the length direction L. An inserting port 41 of the connector 4 is disposed in the width direction W to save space.

Referring to FIG. 1 to FIG. 4, the connecting plate 5 is connected to the bent portion 32 of the FPC 3 and is fixedly connected to the outer surface 22 of the end plate 2 in the length direction L. The FPC 3 is a flexible board, and the connecting plate 5 can be bonded to the bent portion 32 of the FPC 3. The bent portion 32 of the FPC 3 and the outer surface 22 of the end plate 2 can be fixed by the connecting plate 5 in multiple manners. One fixing manner is that the connecting plate 5 comprises an exposed portion 51 exceeding the bent portion 32 of the FPC 3, and the connecting plate 5 and the outer surface 22 of the end plate 2 are fixed by the exposed portion 51 of the connecting plate 5 so as to indirectly fix the bent portion 32 of the FPC 3 and the outer surface 22 of the end plate 2. In an example, the connecting plate 5 comprises an exposed portion 51 downwardly exceeding the bottom end of the bent portion 32 of the FPC 3, the exposed portion 51 is located on the lower side of the connector 4 and fixed to the outer surface 22 of the end plate 2 in the length direction L, so that the bent portion 32 of the FPC 3 and the end plate 2 are indirectly fixed by the exposed portion 51 of the connecting plate 5. The battery module further comprises a third fastener F3, and the exposed portion 51 and the outer surface 22 of the end plate 2 can be fixed by the third fastener F3. In another example, the connecting plate 5 comprises an exposed portion 51 of the connecting plate 5 exceeding from both ends of the bent portion 32 in the width direction W, and the exposed portion 51 is located on both sides of the connector 4 in the width direction W, and is fixed to the outer surface 22 of the end plate 2, so that the bent portion 32 of the FPC 3 and the end plate 2 are indirectly fixed by the exposed portion 51 of the connecting plate 5. The exposed portion 51 located on both sides of the connector 4 in the width direction W and the outer surface 22 of the end plate 2 can also be fixed by the third fastener F3. Another fixing manner is to fix the connecting plate 5, the outer surface 22 of the end plate 2, and the bent portion 32 of the FPC 3 together. In yet another example, the battery module further comprises a fourth fastener F4 located on the upper side of the connector 4, and the connecting plate 5, the outer surface 22 of the end plate 2, and the bent portion 32 of the FPC 3 are fixed together by the fourth fastener F4. In still a further fixing manner, the fixing manner of fixing the connecting plate 5 and the outer surface 22 of the end plate 2 by the exposed portion 51 of the connecting plate 5 and the fixing manner of fixing the connecting plate 5, the outer surface 22 of the end plate 2 and the bent portion 32 of the FPC 3 together are combined. The following takes the combination of the fixing manner of fixing the connecting plate 5 and the outer surface 22 of the end plate 2 by the exposed portion 51 of the connecting plate 5 which downward exceeds the bottom end of the bent portion 32 of the FPC 3 and the fixing manner of fixing the connecting plate 5, the outer surface 22 of the end plate 2 and the bent portion 32 of the FPC 3 together as an example for explanation. As shown in FIG. 1 to FIG. 4, the battery module comprises a third fastener F3 and a fourth fastener F4. The connecting plate 5 comprises the exposed portion 51 which downward exceeds the bottom end of the bent portion 32 of the FPC 3, the exposed portion 51 is located on the lower side of the connector 4, and is fixed to the outer surface 22 of the end plate 2 in the length direction L by the third fastener F3. The fourth fastener F4 is located on the upper side of the connector 4, and the connecting plate 5, the outer surface 22 of the end plate 2 and the bent portion 32 of the FPC 3 are fixed together by the fourth fastener F4. Wherein, the third fastener F3 and the fourth fastener F4 can be buckling nails, occupy a small space and are firmly connected. Correspondingly, a cavity 23 is formed in the end plate 2, and the wall 231 of the cavity 23 is provided with a buckling groove G, and the buckling nails are buckled in the buckling groove G. The end plate 2 provided with the cavity 23 therein also reduces the weight of the battery module. The fixing manner in which the bent portion 32 of the FPC 3 and the outer surface 22 of the end plate 2 are fixed by the connecting plate 5 can be selected according to specific needs.

The bent portion 32 of the FPC 3 is fixedly connected to the outer surface 22 of the end plate 2, an additional plastic member fixing connector 4 is not required to be added, the extra space in the height direction of the battery module is not occupied, and the end plate 2 is not required to be grooved to avoid stress concentration of the end plate 2. Moreover, when the connector 4 is subjected to vibration shock, the flexible characteristic of the FPC 3 can be used to transmit and release the shock to ensure the service life of the battery module.

In the following, the fixing manner in which the bent portion 32 of the FPC 3 is fixedly connected to the top of the end plate 2 will be described.

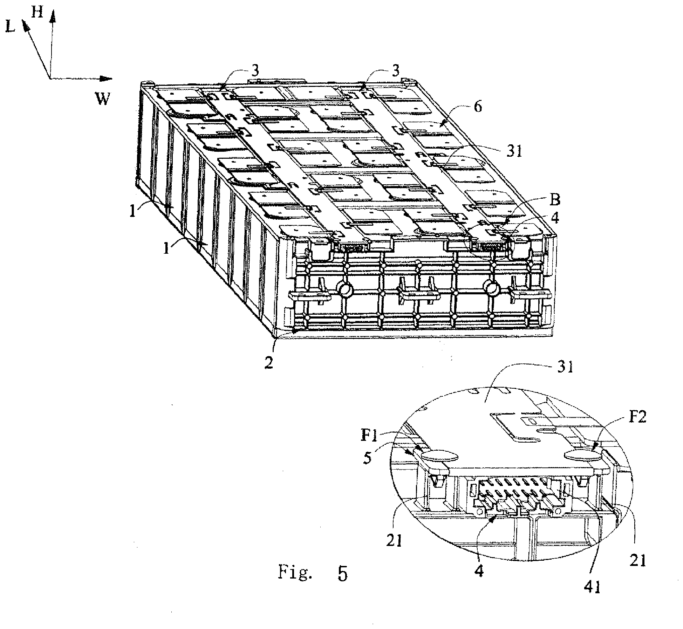

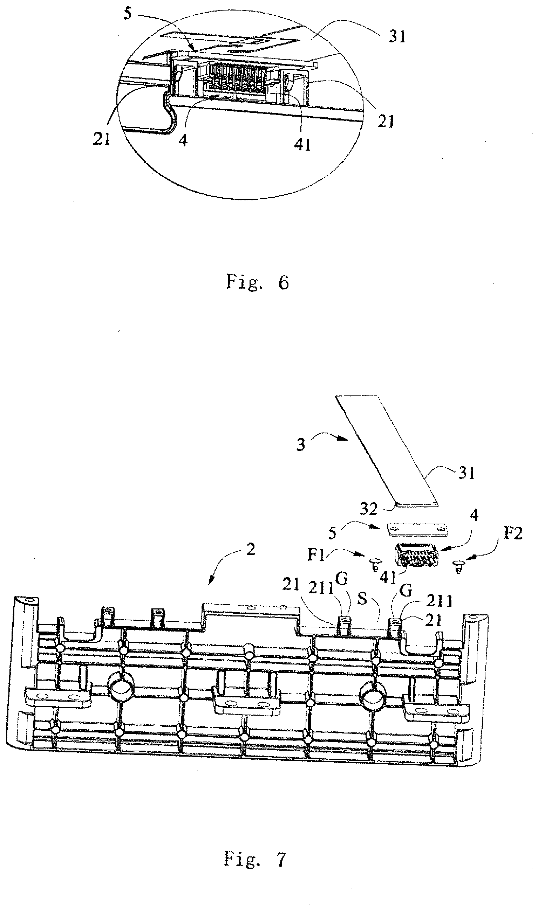

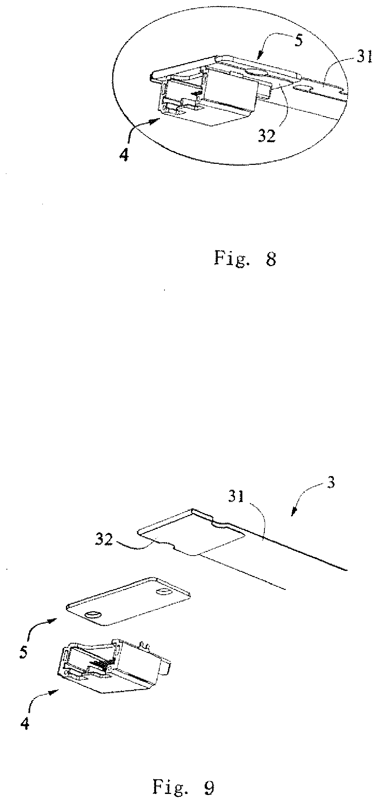

FIG. 5 is a three-dimensional diagram of the battery module according to another embodiment of the utility model. FIG. 6 is an enlarged three-dimensional diagram of the circle B in FIG. 5 from another angle. FIG. 7 is an exploded three-dimensional diagram of part of components of the battery module of FIG. 4. FIG. 8 is a partially enlarged three-dimensional diagram of part of components of the battery module of FIG. 4. FIG. 9 is an exploded three-dimensional diagram of part of components of the battery module of FIG. 8.

In the embodiment of FIG. 5 to FIG. 9, the end plate 2 is provided with two projections 21 protruding upward from the top of the end plate 2, and a containing space S is formed between the two projections 21. The main body portion 31 and the bent portion 32 of the FPC 3 are overlapped in the height direction H, and the connecting plate 5 is located between the main body portion 31 and the bent portion 32 of the FPC 3 in the height direction H. The connecting plate 5 is fixed to the two protrusions 21, and the connector 4 is located in the receiving space S. The inserting port 41 of the connector 4 faces the outside of the battery module in the length direction L, so that the connector 4 does not occupy an extra height space of the battery module. The battery module further comprises a first fastener F1 and a second fastener F2 which are respectively located on both sides of the connector 4 in the width direction W. The connecting plate 5, the main body portion 31 of the FPC 3, the bent portion 32 of the FPC 3 and the projections 21 of the end plate 2 are fixed by the first fastener F1 and the second fastener F2. The first fastener F1 and the second fastener F2 can be buckling nails, and the protrusions 21 of the end plate 2 are hollow inside. The top walls 211 of the protrusions 21 are provided with buckling grooves G, and the buckling nails are buckled in the buckling grooves G to be fixed. The connecting plate 5 can be bonded to the bent portion 32 and the main body portion 31 of the FPC 3. The connector 4 fixedly connected to the bent portion 32 of the FPC 3 is contained by the two protrusions 21 protruding upward on the top of the end plate 2, and an additional plastic member fixing connector 4 is not required to be added. The main body portion 31 and the bent portion 32 of the FPC 3 are overlapped in the height direction H to reduce the influence of the FPC 3 on the height of the battery module. The flexibility of the FPC 3 is fully used to transmit and release the shock caused by a vibration working condition.

In the example shown in the drawing, the connector 4 and the connecting plate 5 are respectively located on opposite sides of the bent portion 32 of the FPC 3. The connector 4 can be connected to the FPC 3 electrically by soldering specifically, and the part where the connector 4 and the FPC 3 are soldered is covered with glue to protect the soldering position from being affected and separated by the vibration in the later stage.

Finally, the connecting plate 5 can be selectively set as needed. For example, the connecting plate 5 can be eliminated, and the FPC 3 can be directly fixed by appropriately increasing the strength of the FPC 3 per se while the requirement on the flexibility is met (that is, the strength requirement of connecting and fixing is met).

In summary, in the battery module according to the utility model, the connector 4 is fixedly connected to the bent portion 32 of the FPC 3, and the bent portion 32 is fixedly connected to the end plate 2. Therefore, the connector 4 is fixed to the end plate 2 by the FPC 3. When the connector 4 is subjected to vibration shock, the flexible characteristic of the FPC 3 can be used to transmit and release the shock.

The above detailed description describes various exemplary embodiments, but is not intended to be limited to the specifically disclosed combinations. Accordingly, unless stated otherwise, the various features disclosed herein can be combined together to form multiple additional combinations that are not shown for the sake of clarity.

The foregoing is only the preferred embodiments of the present application, and is not intended to limit the present application, and various changes and modifications can be made to the present application for those skilled in the art. Any modifications, equivalent substitutions, improvements, etc., made within the spirit and principles of the present application should be within the scope of the present application.

## Claims

1. A battery module, comprising:
a plurality of batteries (1) arranged in a length direction (L);
an end plate (2) disposed at the end part of the plurality of batteries (1) in the length direction (L);
an FPC (3), wherein the FPC (3) comprises a main body portion (31) and a bent portion (32), the main body portion (31) is located above the corresponding battery (1) in a height direction (H) and is electrically connected to the corresponding battery (1), the bent portion (32) is bent and extends from the main body portion (31) and is located on the lower side of the main body portion (31), and the bent portion (32) is fixedly connected to the end plate (2); and
a connector (4), fixedly connected to the bent portion (32) of the FPC (3) and electrically connected to the FPC (3) .

2. The battery module according to claim 1, **characterized in that** the battery module further comprises: a connecting plate (5), connected to the end plate (2) and the bent portion (32) of the FPC (3).

3. The battery module according to claim 2, **characterized in that** the connector (4) and the connecting plate (5) are respectively located on opposite sides of the bent portion (32) of the FPC (3).

4. The battery module according to claim 2, **characterized in that**
the end plate (2) is provided with two protrusions (21) protruding upward from the top of the end plate (2), a containing space (S) is formed between the two protrusions (21),
the main body portion (31) and the bent portion (32) of the FPC (3) are overlapped in the height direction (H);
the connecting plate (5) is located between the main body portion (31) and the bent portion (32) of the FPC (3) in the height direction (H), and the connecting plate (5) is fixed to the two protrusions (21); and
the connector (4) is located in the containing space (S), and an inserting port (41) of the connector (4) faces the outside of the battery module in the length direction (L) .

5. The battery module according to claim 4, **characterized in that** the battery module further comprises a first fastener (F1) and a second fastener (F2) which are respectively located on both sides of the connector (4) in a width direction (W), and the connecting plate (5), the main body portion (31) of the FPC (3), the bent portion (32) of the FPC (3), and the protrusions (21) of the end plate (2) are fixed by the first fastener (F1) and the second fastener (F2) .

6. The battery module according to claim 2, **characterized in that**
the bent portion (32) of the FPC (3) extends downward from the top of the end plate (2) along the outer surface (22) of the end plate (2) in the length direction (L);
the connecting plate (5) is located between the bent portion (32) of the FPC (3) and the outer surface (22) of the end plate (2) in the length direction (L), and is fixed to the outer surface (22) of the end plate (2) in the length direction (L); and
an inserting port (41) of the connector (4) is disposed in the width direction (W).

7. The battery module according to claim 6, **characterized in that** the connecting plate (5) comprises an exposed portion (51) downward exceeding the bottom end of the bent portion (32) of the FPC (3), and the exposed portion (51) is located on the lower side of the connector (4) and is fixed to the outer surface (22) of the end plate (2) in the length direction (L).

8. The battery module according to claim 7, **characterized in that** the battery module further comprises a third fastener (F3), and the exposed portion (51) and the outer surface (22) of the end plate (2) are fixed by the third fastener (F3) .

9. The battery module according to claim 6, **characterized in that** the battery module further comprises a fourth fastener (F4) located on the upper side of the connector (4), and the connecting plate (5), the outer surface (22) of the end plate (2) and the bent portion (32) of the FPC (3) are fixed by the fourth fastener (F4).

10. The battery module according to claim 6, **characterized in that** the battery module further comprises a third fastener (F3) and a fourth fastener (F4); the connecting plate (5) comprises an exposed portion (51) downward exceeding the bottom end of the bent portion (32) of the FPC (3), and the exposed portion (51) is located on the lower side of the connector (4), and is fixed to the outer surface (22) of the end plate (2) in the length direction (L) by the third fastener (F3) ; and the fourth fastener (F4) is located on the upper side of the connector (4), and the connecting plate (5), the outer surface (22) of the end plate (2), and the bent portion (32) of the FPC (3) are fixed by the fourth fastener (F4).

11. The battery module according to claim 6 or 9, **characterized in that** the connecting plate (5) comprises an exposed portion (51) exceeding both ends of the bent portion (32) in the width direction (W), and the exposed portion (51) is located on both sides of the connector (4) in the width direction (W) and is fixed to the outer surface (22) of the end plate (2) in the length direction (L) .
